# EUROPEAN PATENT SPECIFICATION

(11) **EP 4 513 209 B1**
(45) Date of publication and mention of the grant of the patent: **05.08.2026**
(21) Application number: 23850256.1
(22) Date of filing: 26.06.2023
(51) Int. Cl.: G01R 31/36, G01R 31/367, G01R 31/3842, G01R 31/392, G01R 19/00, G01R 19/165, G01R 31/396

(54) **BATTERY MANAGEMENT APPARATUS AND OPERATING METHOD THEREOF**
BATTERIEVERWALTUNGSVORRICHTUNG UND BETRIEBSVERFAHREN DAFÜR
DISPOSITIF DE GESTION DE BATTERIE ET SON PROCÉDÉ DE FONCTIONNEMENT

(30) Priority: 04.08.2022 KR 20220097615
(43) Date of publication of application: 26.02.2025
(73) Proprietor: LG Energy Solution, Ltd., Seoul 07335 (KR)
(72) Inventor: PARK, Jun Cheol, Daejeon 34122 (KR)
(74) Representative: Plasseraud IP
(86) International application number: PCT/KR2023/008868
(87) International publication number: WO 2024/029746

(56) References cited:
- KR-A- 20160 014 940
- KR-A- 20200 117 794
- KR-A- 20210 014 003
- KR-A- 20220 037 169
- KR-A- 20220 096 993
- US-A1- 2010 148 731
- US-A1- 2011 060 538
- HE WEI ET AL: "State of charge estimation for electric vehicle batteries using unscented kalman filtering", MICROELECTRONICS RELIABILITY : AN INTERNAT. JOURNAL & WORLD ABSTRACTING SERVICE, ELSEVIER SCIENCE LTD, GB, vol. 53, no. 6, 16 January 2013 (2013-01-16), pages 840 - 847, XP028550096, ISSN: 0026-2714, DOI: 10.1016/J.MICROREL.2012.11.010

## Description

### [TECHNICAL FIELD]

### CROSS-REFERENCE TO RELATED APPLICATION

This application claims priority to and the benefit of Korean Patent Application No. 10-2022-0097615 filed in the Korean Intellectual Property Office on August 4, 2022.

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

An energy storage system (ESS) battery needs a technique for detecting a defect of a battery because occurrence of the defect may result in a huge accident such as fire, etc. The technique for detecting a defect of a battery has been variously developed, but most methods perform simple comparison such as voltage, current, or temperature deviations of battery cells or voltage drops of a specific battery cell, requiring a method for accurately detecting a defect of a battery. That is, a technique for detecting a battery cell having an abnormal behavior according to a state of a battery is required. Prior art document US2011/060538 discloses a battery management system that senses voltage and current of a battery pack. Look-up tables (LUT) contain pre-recorded impulse responses of healthy and unhealthy battery packs of the the same kind, indexed by a measured and calculated battery state of charge. The state of health of the battery is estimated by finding the LUT entry that best fits the measured battery data.

### [DISCLOSURE]

### [TECHNICAL PROBLEM]

Embodiments disclosed herein aim to provide a battery management apparatus and an operating method thereof in which an unusual abnormal behavior undetectable based on a deviation between battery cells may be detected.

Embodiments disclosed herein aim to provide a battery management apparatus and an operating method thereof in which abnormality of a battery may be detected by estimating future voltage information based on voltage information and current information for a specific period of time.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein is disclosed in the appended claims. Specifically, the invention provides an apparatus according to claim 1.

An operating method of a battery management apparatus is also provided, according to claim 12.

### [ADVANTAGEOUS EFFECTS]

The battery management apparatus and the operating method thereof according to an embodiment disclosed herein may detect a special abnormal behavior undetectable through simple comparison in voltage or current between battery cells.

The battery management apparatus and the operating method thereof according to an embodiment disclosed herein may determine a state of the battery by estimating voltage information for the second period of time based on the first current information and the voltage information and comparing the estimated voltage information with the measured voltage information.

The battery management apparatus and the operating method thereof according to an embodiment disclosed herein may determine the state of the battery by training an algorithm related to a relationship between the current information of the battery and the voltage information of the battery for a specific period of time.

The battery management apparatus and the operating method thereof according to an embodiment disclosed herein may determine the state of the battery by storing the trained algorithm and estimating voltage information through an appropriate algorithm for the replaced battery even when the battery is replaced.

The battery management apparatus and the operating method thereof according to an embodiment disclosed herein may estimate voltage information by using the same algorithm for batteries having similar SoH and train a new algorithm to estimate voltage information of the battery when the SoH change over time.

Moreover, various effects recognized directly or indirectly from the disclosure may be provided.

### [DESCRIPTION OF DRAWINGS]

FIG. 1 is a block diagram of a general battery pack.
FIG. 2 is a block diagram of a battery management apparatus according to an embodiment disclosed herein.
FIG. 3 is a view showing an example of determining a state of a battery by a battery management apparatus, according to an embodiment disclosed herein.
FIG. 4 shows an example in which a battery management apparatus stores an algorithm, according to an embodiment disclosed herein.
FIG. 5 is a flowchart of an operating method of a battery management apparatus according to an embodiment disclosed herein.
FIGS. 6 to 7 are flowcharts showing in detail an operating method of a battery management apparatus, according to an embodiment disclosed herein.
FIG. 8 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

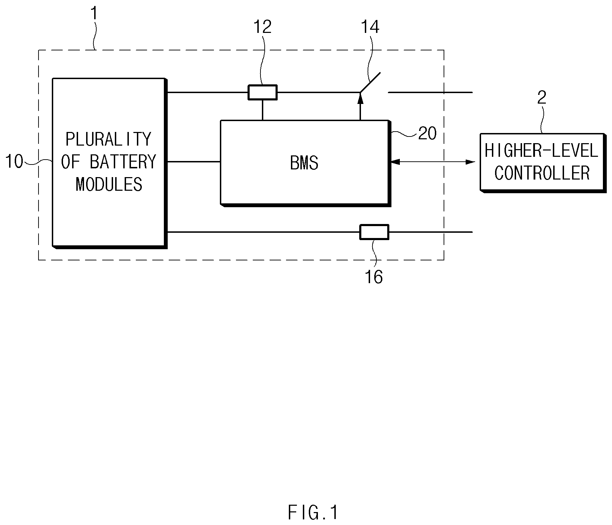

FIG. 1 is a block diagram of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system 20 for control and management to prevent overcharging and over-discharging by monitoring voltage, current, temperature, etc., of the battery pack 1. The battery pack 1 may include the battery module 10, the sensor 12, 16, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

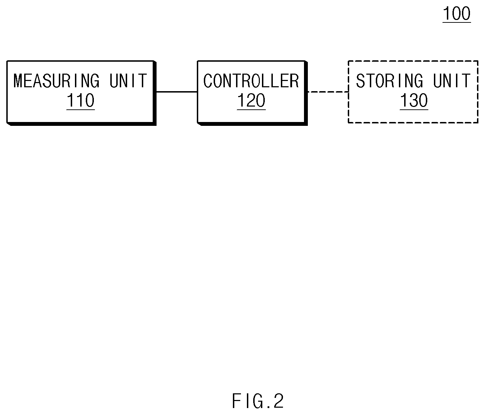

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1.

The higher-level controller 2 may transmit a control signal regarding the battery module 10 to the battery management system 20. Thus, the battery management system 20 may also be controlled in terms of an operation thereof based on a signal applied from the higher-level controller 2.

FIG. 2 is a block diagram of a battery management apparatus according to an embodiment disclosed herein.

Referring to FIG. 2, the battery management apparatus 100 according to an embodiment disclosed herein may include a measuring unit 110 and a controller 120. Depending on an embodiment, the battery management apparatus 100 may be included in the battery management system 20 of FIG. 1 or may be another device that is different from the battery management system 20 of FIG. 1. According to an embodiment, the battery management apparatus 100 may further include a storing unit 130.

The measuring unit 110 may measure a current and a voltage of a battery. For example, the measuring unit 110 may measure first current information related to a current of a battery, measured for a first period of time, and first voltage information related to a voltage of the battery, measured for the first period of time. In another example, the measuring unit 110 may include a current sensor and a voltage sensor and measure the first current information and the first voltage information through the current sensor and the voltage sensor. In another example, the measuring unit 110 may measure current information and voltage information of each of a battery pack, a battery module, or a battery cell included in the battery. According to an embodiment, the first period of time may be one month, without being limited thereto. According to another embodiment, the first period of time may be a period of time for which a state of health (SoH) of the battery does not change.

According to an embodiment, the measuring unit 110 may measure the first current information and the first voltage information for every first period of time. For example, when the first period of time is one month, the measuring unit 110 may measure the current information of the battery and the voltage information of the battery for the first one month, and measure the current information of the battery and the voltage information of the battery again for the next one month. That is, the measuring unit 110 may repeatedly measure the first current information and the first voltage information.

The measuring unit 110 may measure second current information related to a current of the battery for a second period of time after the first period of time, and second voltage information related to a voltage of the battery for the second period of time. For example, the second period of time may be one day, without being limited thereto. In another example, the second period of time may be a period of time for which the controller 120 estimates voltage information of the battery.

According to an embodiment, the measuring unit 110 may measure the second current information and the second voltage information for every second period of time. For example, when the second period of time is one day, the measuring unit 110 may measure the second current information and the second voltage information for the first one day, and measure the second current information and the second voltage information again for the next day. That is, the measuring unit 110 may repeatedly measure the second current information and the second voltage information.

The controller 120 may estimate a voltage of the battery for the second period of time after the first period of time based on the first current information and the first voltage information to generate voltage estimation information.

The controller 120 may determine a state of the battery based on the estimated voltage estimation information and the second voltage information related to the voltage of the battery measured for the second period of time. For example, the controller 120 may compare the generated voltage estimation information with the second voltage information and determine that abnormality occurs in the battery when a difference between the voltage estimation information and the second voltage information is greater than or equal to a threshold value. According to an embodiment, the controller 120 may determine that abnormality occurs in the battery based on at least any one of an average of differences between voltage estimation information and second voltage information, an accumulated difference for the second period of time, an absolute value of the difference, and a root mean square of the differences, without being limited to the foregoing method.

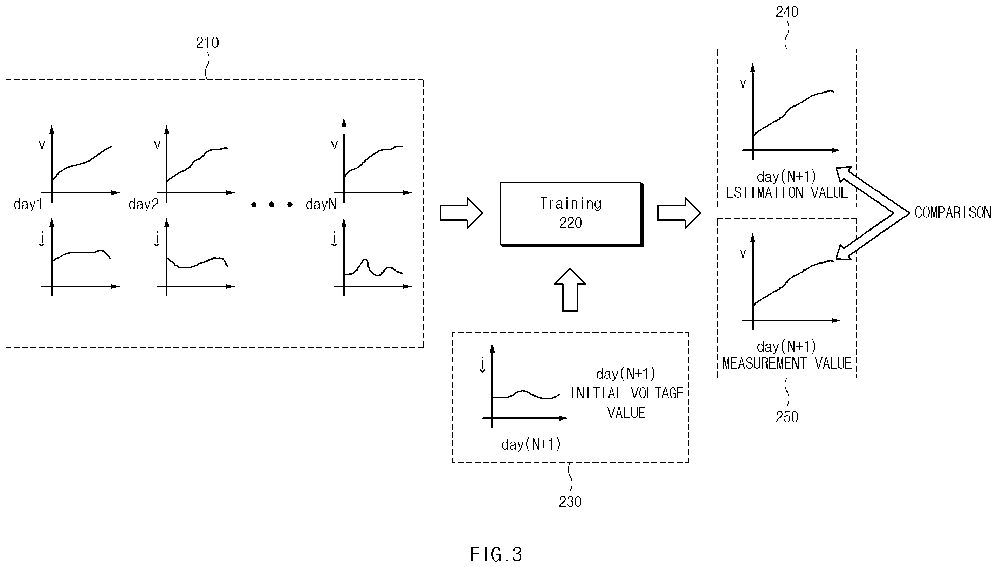

FIG. 3 is a view showing an example of determining a state of a battery by a battery management apparatus, according to an embodiment disclosed herein. According to an embodiment, an example shown in FIG. 3 may be performed by the battery management apparatus 100 of FIG. 2.

Referring to FIG. 3, the measuring unit 110 may include first current information and first voltage information 210. For example, a first period of time may be from day 1 to day N, and the measuring unit 110 may measure a current of a battery from day 1 to day N and a voltage of the battery from day 1 to day N.

The measuring unit 110 may also measure second current information and initial voltage information 230 of a second period of time and measure second voltage information 250. For example, the second period of time may be day N+1, and the measuring unit 110 may measure current information of day N+1 and voltage information of day N+1.

The controller 120 may also generate voltage estimation information 240 based on the second current information and the initial voltage information 230 of the second period of time. For example, the controller 120 may estimate voltage information of day N+1 based on the current information of day N+1 and the initial voltage information of day N+1.

According to an embodiment, the controller 120 learns the first current information and the first voltage information 210 through a long short-term memory (LSTM) algorithm as indicated by 220. For example, the controller 120 may train an algorithm related to a relationship between the first current information and the first voltage information 210 as indicated by 220.

The controller 120 may generate the voltage estimation information 240 based on the trained algorithm. For example, the controller 120 may input the current information of day N+1 and the initial voltage information 230 of day N+1 to the trained algorithm, and generate and output the voltage information 240 of day N+1 estimated based on the algorithm.

According to an embodiment, the controller 120 may update an algorithm based on the second current information and the second voltage information. For example, the controller 120 may train an algorithm related to a relationship between voltage information of a battery and current information of the battery, further based on the second current information and the second voltage information in addition to the first current information and the first voltage information.

According to an embodiment, the controller 120 may update the algorithm based on the current information of the battery measured for every second period of time and the voltage information of the battery measured for every second period of time. For example, the controller 120 may train and update the algorithm based on current information of day 1 to day N+1 and the voltage information of day 1 to day N+1. In another example, the controller 120 may update the algorithm based on the current information of the battery of day N+1 and the voltage information of the battery of day N+1. According to an embodiment, the controller 120 may estimate voltage information of the battery of day N+2 based on the updated algorithm to generate voltage estimation information of the battery of day N+2.

The controller 120 may determine a state of the battery based on the generated voltage estimation information 240 and the second voltage information 250. For example, the controller 120 may determine the state of the battery by comparing the voltage estimation information 240 with the second voltage information 250. In another example, the controller 120 may determine that abnormality occurs in the battery when a difference between the voltage estimation information 240 and the second voltage information 250 is greater than or equal to a threshold value.

Referring back to FIG. 2, the controller 120 may generate voltage estimation information regarding the battery having a SoH in a specific range. For example, when the SoH falls out of the specific range, the relationship between the current information of the battery and the voltage information of the battery may change, such that the controller 120 may generate voltage estimation information through the same algorithm for a battery having a SoH in the specific range.

According to an embodiment, when the SoH of the battery falls out of the specific range, the controller 120 may change the algorithm for generating voltage estimation information. For example, the controller 120 may change the algorithm for every first period of time.

According to an embodiment, the battery management apparatus 100 may further include the storing unit 130. The storing unit 130 may store the algorithm trained for every first period of time.

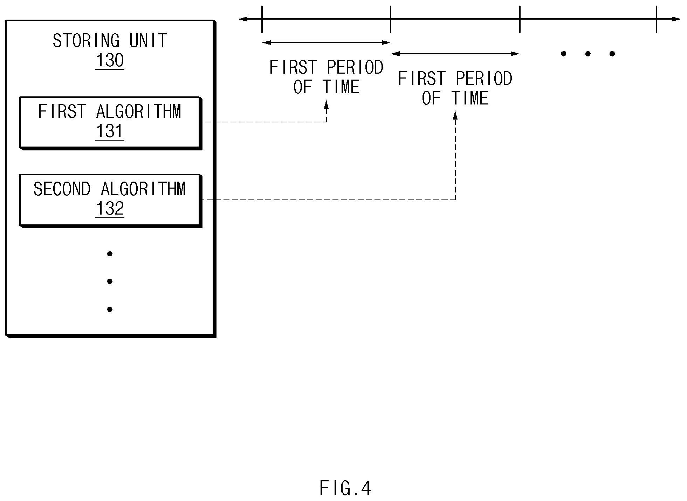

FIG. 4 shows an example in which a battery management apparatus stores an algorithm, according to an embodiment disclosed herein.

Referring to FIG. 4, the storing unit 130 according to an embodiment disclosed herein may store the algorithm trained for every first period of time. Thus, the storing unit 130 may store a plurality of algorithms 131 and 132.

According to an embodiment, a first algorithm 131 stored in the storing unit 130 may be an algorithm trained by the controller 120 for the initial first period of time. In addition, a second algorithm 132 stored in the storing unit 130 may be an algorithm trained by the controller 120 during the second first period of time. That is, the controller 120 may train an algorithm related to a relationship between the current information of the battery and the voltage information of the battery for every first period of time and store the trained algorithm in the storing unit 130.

According to an embodiment, the controller 120 may generate voltage estimation information for every second period of time after the initial first period of time based on the first algorithm 131. The controller 120 may train the second algorithm 132 based on the second first current information and the second first voltage information by accumulating the current information of the battery measured for every second period of time and the voltage information of the battery measured for every second period of time. In this case, the controller 120 may generate voltage estimation information for every second period of time after the second first period of time based on the second algorithm 132.

According to an embodiment, the controller 120 may generate the voltage estimation information based on an algorithm corresponding to each battery. For example, the controller 120 may generate voltage estimation information of a replaced battery for the second period of time based on the algorithm stored in the storing unit 130 when there is the replaced battery. When the battery is replaced, a SoH indicating a level of deterioration may be different from those of batteries not replaced, such that the controller 120 may generate voltage estimation information of the replaced battery based on an algorithm corresponding to a period for which the replaced battery is included.

The battery management apparatus 100 according to an embodiment disclosed herein may detect a special abnormal behavior undetectable through simple comparison in voltage or current between battery cells.

The battery management apparatus 100 according to an embodiment disclosed herein may determine a state of the battery by estimating voltage information for the second period of time based on the first current information and the voltage information and comparing the estimated voltage information with the measured voltage information.

The battery management apparatus 100 according to an embodiment disclosed herein may determine the state of the battery by training an algorithm related to a relationship between the current information of the battery and the voltage information of the battery for a specific period of time.

The battery management apparatus 100 according to an embodiment disclosed herein may determine the state of the battery by storing the trained algorithm and estimating voltage information through an appropriate algorithm for the replaced battery even when the battery is replaced.

The battery management apparatus 100 according to an embodiment disclosed herein may estimate voltage information by using the same algorithm for batteries having similar SoH and train a new algorithm to estimate voltage information of the battery when the SoH change over time.

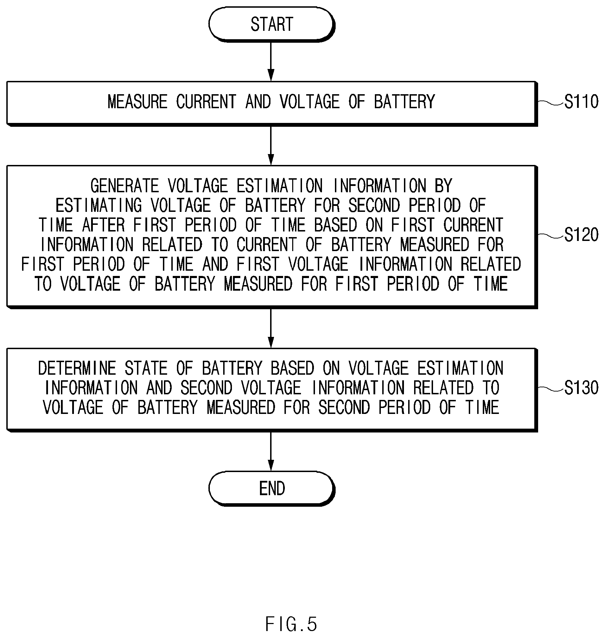

FIG. 5 is a flowchart of an operating method of a battery management apparatus according to an embodiment disclosed herein.

According to an embodiment, operations shown in FIG. 5 may be performed by the battery management apparatus 100 of FIG. 2.

Referring to FIG. 5, an operating method of the battery management apparatus 100 according to an embodiment disclosed herein may include operation S110 of measuring a current and a voltage of a battery, operation S120 of generating voltage estimation information by estimating the voltage of the battery for a second period of time after a first period of time based on first current information related to a current of the battery measured for a first period of time and first voltage information related to a voltage of the battery measured for the first period of time, and operation S130 of determining a state of the battery based on the voltage estimation information and second voltage information related to a voltage of the battery measured for the second period of time.

In operation S110, the measuring unit 110 may measure a current and a voltage of a battery. For example, the measuring unit 110 may measure first current information related to a current of a battery, measured for a first period of time, and first voltage information related to a voltage of the battery, measured for the first period of time. In another example, the measuring unit 110 may include a current sensor and a voltage sensor and measure the first current information and the first voltage information through the current sensor and the voltage sensor. In another example, the measuring unit 110 may measure current information and voltage information of each of a battery pack, a battery module, or a battery cell included in the battery. According to an embodiment, the first period of time may be one month, without being limited thereto. According to another embodiment, the first period of time may be a period of time for which a state of health (SoH) of the battery does not change.

According to an embodiment, in operation S100, the measuring unit 110 may measure the first current information and the first voltage information for every first period of time. For example, when the first period of time is one month, the measuring unit 110 may measure the current information of the battery and the voltage information of the battery for the first one month, and measure the current information of the battery and the voltage information of the battery again for the next one month. That is, the measuring unit 110 may repeatedly measure the first current information and the first voltage information.

In operation S110, the measuring unit 110 may measure second current information related to a current of the battery for a second period of time after the first period of time, and second voltage information related to a voltage of the battery for the second period of time. For example, the second period of time may be one day, without being limited thereto. In another example, the second period of time may be a period of time for which the controller 120 estimates voltage information of the battery.

According to an embodiment, in operation S110, the measuring unit 110 may measure the second current information and the second voltage information for every second period of time. For example, when the second period of time is one day, the measuring unit 110 may measure the second current information and the second voltage information for the first one day, and measure the second current information and the second voltage information again for the next day. That is, the measuring unit 110 may repeatedly measure the second current information and the second voltage information.

In operation S120, the measuring unit 120 may generate the voltage estimation information based on the first current information related to the current of the battery, measured for the first period of time, and the first voltage information related to the voltage of the battery, measured for the first period of time. For example, the controller 120 may train the algorithm related to the relationship between the first current information and the first voltage information and generate voltage estimation information based on the trained algorithm, second current information related to the current of the battery, measured for the second period of time, and the initial voltage information of the second period of time.

In operation S130, the controller 120 may determine the state of the battery based on the voltage estimation information and the second voltage information. For example, the controller 120 may determine that abnormality occurs in the battery when a difference between the voltage estimation information and the second voltage information related to the voltage of the battery measured for the second period of time is greater than or equal to the threshold value.

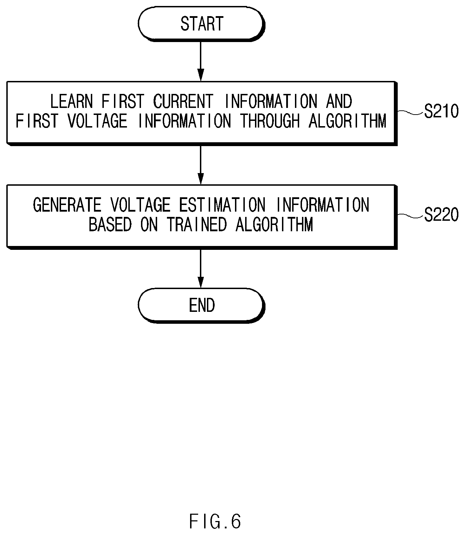

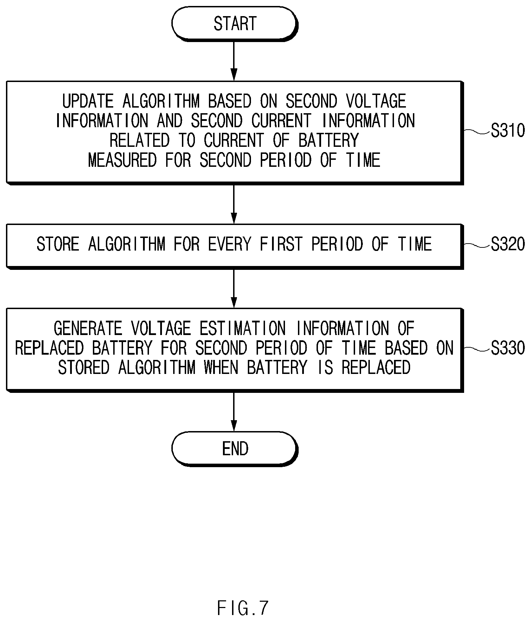

FIGS. 6 to 7 are flowcharts showing in detail an operating method of a battery management apparatus, according to an embodiment disclosed herein. According to an embodiment, operations shown in FIGS. 6 and 7 may be performed by the battery management apparatus 100 of FIG. 2.

Referring to FIG. 6, an operating method of the battery control apparatus 100 according to an embodiment disclosed herein may include operation S210 of learning first current information and first voltage information through an algorithm and operation S220 of generating voltage estimation information based on the trained algorithm. According to an embodiment, operations S210 and S220 may be included in operation S120 of FIG. 5.

That is, in operation S210, the controller 120 learns the first current information and the first voltage information through the algorithm. For example, the controller 120 learns the first current information and the first voltage information through an LSTM algorithm. In another example, the controller 120 may train an algorithm related to a relationship between the first current information and the first voltage information.

In operation S220, the controller 120 may generate the voltage estimation information based on the trained algorithm.

Referring to FIG. 7, the operating method of the battery management apparatus 100 according to an embodiment disclosed herein may include operation S310 of updating an algorithm based on the second voltage information and the second current information related to the current of the battery measured for the second period of time and operation S330 of predicting voltage information of the replaced battery for the second period of time based on the stored algorithm when the battery is replaced.

In operation S310, the controller 120 may update the algorithm based on the second voltage information and the second current information related to the current of the battery measured for the second period of time. For example, the controller 120 may train an algorithm related to a relationship between voltage information and current information, further based on the second current information and the second voltage information in addition to the first current information and the first voltage information. According to an embodiment, the controller 120 may update the algorithm based on the current information of the battery measured for every second period of time and the voltage information of the battery measured for every second period of time.

In operation S320, the storing unit 130 may store the algorithm for every first period of time. For example, the storing unit 130 may store a plurality of algorithms by storing the algorithm for every first period of time.

In operation S330, the controller 120 may generate the voltage estimation information of the replaced battery for the second period of time based on the stored algorithm when the battery is replaced. For example, the controller 120 may generate voltage estimation information of a replaced battery for the second period of time based on the algorithm stored in the storing unit 130 when there is the replaced battery. When the battery is replaced, a SoH indicating a level of deterioration may be different from those of batteries not replaced, such that the controller 120 may generate voltage estimation information of the replaced battery based on an algorithm corresponding to a period for which the replaced battery is included.

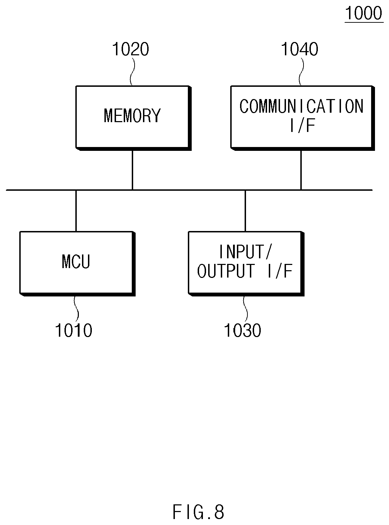

FIG. 8 is a block diagram showing a hardware configuration of a computing system for performing an operating method of a battery management apparatus, according to an embodiment disclosed herein.

Referring to FIG. 8, a computing system 1000 according to an embodiment disclosed herein may include an MCU 1010, a memory 1020, an input/output I/F 1030, and a communication I/F 1040.

The MCU 1010 may be a processor that executes various programs (e.g., a program for collecting battery voltage information or current information, a program for training an algorithm related to a relationship between the battery voltage information and the battery current information, a program for estimating the battery voltage information, a program for determining whether the battery is replaced, a program for determining a state of the battery, etc.) stored in the memory 1020, processes various information including the battery voltage information, the battery current information, the algorithm for estimating the battery voltage information, the battery state information, etc., through these programs, and executes the above-described functions of the controller included in the battery management apparatus shown in FIG. 2.

The memory 1020 may store various programs such as the program for collecting the battery voltage information or current information, the program for training the algorithm related to the relationship between the battery voltage information and the battery current information, the program for estimating the battery voltage information, the program for determining whether the battery is replaced, the program for determining the state of the battery, etc. The memory 1020 may store various information such as the voltage information of the battery, the current information of the battery, the algorithm for estimating the battery voltage information, the battery state information, etc. According to an embodiment, the memory 1020 may be substantially the same as the storing unit 130 of FIG. 2.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive information such as the voltage information of the battery, the current information of the battery, the algorithm for estimating the battery voltage information, the battery state information from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. The scope of the invention is defined by the claims.

## Claims

1. A battery management apparatus (100) comprising:
a measuring unit (110) configured to measure a current and a voltage of a battery; and
a controller (120) configured to:
generate voltage estimation information by estimating the voltage of the battery for a second period of time after a first period of time based on first current information related to the current of the battery measured for the first period of time and first voltage information related to the voltage of the battery measured for the first period of time,
determine a state of the battery based on the voltage estimation information and second voltage information related to the voltage of the battery measured for the second period of time;
wherein the controller (120) is further configured to:
learn the first current information and the first voltage information through an algorithm; and
generate the voltage estimation information based on the trained algorithm.

2. The battery management apparatus of claim 1, wherein the controller (120) is further configured to determine an abnormality occurs in the battery when a difference between the voltage estimation information and the second voltage information is greater than or equal to a threshold value.

3. The battery management apparatus of claim 1, wherein the controller (120) is further configured to generate the voltage estimation information based on second current information related to the current of the battery measured for the second period of time and initial voltage information of the battery measured for the second period of time.

4. The battery management apparatus of claim 1, wherein the algorithm comprises a long short-term memory, LSTM, algorithm.

5. The battery management apparatus of claim 1, wherein the controller (120) is further configured to update the algorithm based on the second voltage information and second current information related to the current of the battery measured for the second period of time.

6. The battery management apparatus of claim 1, further comprising a storing unit (130), wherein the storing unit (130) is further configured to store an algorithm trained every first period of time.

7. The battery management apparatus of claim 6, wherein the controller (120) is further configured to generate voltage estimation information of a replacement battery for the second period of time based on the stored algorithm when there is the replacement battery.

8. The battery management apparatus of claim 1, wherein the controller (120) is further configured to generate the voltage estimation information when the battery has a state of health, SoH, in a specific range.

9. The battery management apparatus of claim 8, wherein the controller (120) is further configured to change an algorithm for generating the voltage estimation information when the SoH of the battery falls out of the specific range.

10. The battery management apparatus of claim 1, wherein the controller (120) is further configured to update the algorithm for generating the voltage estimation information for every first period of time.

11. The battery management apparatus of claim 1, wherein the controller (120) is further configured to:
train an algorithm related to a relationship between the first current information and the first voltage information; and
generate the voltage estimation information based on the trained algorithm.

12. An operating method of a battery management apparatus (100), the operating method comprising:
measuring (S110) a current and a voltage of a battery; and
generating voltage estimation information (S120) by estimating the voltage of the battery for a second period of time after a first period of time based on first current information related to the current of the battery measured for the first period of time and first voltage information related to the voltage of the battery measured for the first period of time; and
determining (S130) a state of the battery based on the voltage estimation information and second voltage information related to the voltage of the battery measured for the second period of time,
wherein generating the voltage estimation information comprises:
learning the first current information and the first voltage information through an algorithm; and
generating the voltage estimation information based on the trained algorithm.

13. The operating method of claim 13, wherein determining (S130) the state of the battery comprises determining an abnormality occurs in the battery when a difference between the voltage estimation information and the second voltage information is greater than or equal to a threshold value.

## Patentansprüche

1. Batteriemanagementvorrichtung (100), umfassend: eine Messeinheit (110), die konfiguriert ist, um einen Strom und eine Spannung einer Batterie zu messen; und eine Steuerung (120), die konfiguriert ist, um: Spannungsschätzungsinformationen durch Schätzen der Spannung der Batterie für einen zweiten Zeitraum nach einem ersten Zeitraum basierend auf ersten Strominformationen, die sich auf den für den ersten Zeitraum gemessenen Strom der Batterie beziehen, und ersten Spannungsinformationen, die sich auf die für den ersten Zeitraum gemessene Spannung der Batterie beziehen, zu erzeugen, einen Zustand der Batterie basierend auf den Spannungsschätzungsinformationen und zweiten Spannungsinformationen, die sich auf die für den zweiten Zeitraum gemessene Spannung der Batterie beziehen, zu bestimmen; wobei die Steuerung (120) ferner konfiguriert ist, um: die ersten Strominformationen und die ersten Spannungsinformationen durch einen Algorithmus zu lernen; und die Spannungsschätzungsinformationen basierend auf dem trainierten Algorithmus zu erzeugen.

2. Batteriemanagementvorrichtung nach Anspruch 1, wobei die Steuerung (120) ferner konfiguriert ist, um zu bestimmen, dass eine Anomalie in der Batterie auftritt, wenn eine Differenz zwischen den Spannungsschätzungsinformationen und den zweiten Spannungsinformationen größer als oder gleich einem Schwellenwert ist.

3. Batteriemanagementvorrichtung nach Anspruch 1, wobei die Steuerung (120) ferner konfiguriert ist, um die Spannungsschätzungsinformationen basierend auf zweiten Strominformationen, die sich auf den für den zweiten Zeitraum gemessenen Strom der Batterie beziehen, und anfänglichen Spannungsinformationen der für den zweiten Zeitraum gemessenen Batterie zu erzeugen.

4. Batteriemanagementvorrichtung nach Anspruch 1, wobei der Algorithmus einen Algorithmus mit langem Kurzzeitgedächtnis, LSTM, umfasst.

5. Batteriemanagementvorrichtung nach Anspruch 1, wobei die Steuerung (120) ferner konfiguriert ist, um den Algorithmus basierend auf den zweiten Spannungsinformationen und den zweiten Strominformationen, die sich auf den für den zweiten Zeitraum gemessenen Strom der Batterie beziehen, zu aktualisieren.

6. Batteriemanagementvorrichtung nach Anspruch 1, ferner umfassend eine Speichereinheit (130), wobei die Speichereinheit (130) ferner konfiguriert ist, um einen für jeden ersten Zeitraum trainierten Algorithmus zu speichern.

7. Batteriemanagementvorrichtung nach Anspruch 6, wobei die Steuerung (120) ferner konfiguriert ist, um Spannungsschätzungsinformationen einer Ersatzbatterie für den zweiten Zeitraum basierend auf dem gespeicherten Algorithmus zu erzeugen, wenn die Ersatzbatterie vorhanden ist.

8. Batteriemanagementvorrichtung nach Anspruch 1, wobei die Steuerung (120) ferner konfiguriert ist, um die Spannungsschätzungsinformationen zu erzeugen, wenn die Batterie einen Gesundheitszustand, SoH, in einem spezifischen Bereich aufweist.

9. Batteriemanagementvorrichtung nach Anspruch 8, wobei die Steuerung (120) ferner konfiguriert ist, um einen Algorithmus zum Erzeugen der Spannungsschätzungsinformationen zu ändern, wenn der SoH der Batterie aus dem spezifischen Bereich fällt.

10. Batteriemanagementvorrichtung nach Anspruch 1, wobei die Steuerung (120) ferner konfiguriert ist, um den Algorithmus zum Erzeugen der Spannungsschätzungsinformationen für jeden ersten Zeitraum zu aktualisieren.

11. Batteriemanagementvorrichtung nach Anspruch 1, wobei die Steuerung (120) ferner konfiguriert ist, um: einen Algorithmus zu trainieren, der sich auf eine Beziehung zwischen den ersten Strominformationen und den ersten Spannungsinformationen bezieht; und die Spannungsschätzungsinformationen basierend auf dem trainierten Algorithmus zu erzeugen.

12. Betriebsverfahren einer Batteriemanagementvorrichtung (100), wobei das Betriebsverfahren umfasst: Messen (S110) eines Stroms und einer Spannung einer Batterie; und Erzeugen von Spannungsschätzungsinformationen (S120) durch Schätzen der Spannung der Batterie für einen zweiten Zeitraum nach einem ersten Zeitraum basierend auf ersten Strominformationen, die sich auf den für den ersten Zeitraum gemessenen Strom der Batterie beziehen, und ersten Spannungsinformationen, die sich auf die für den ersten Zeitraum gemessene Spannung der Batterie beziehen; und Bestimmen (S130) eines Zustands der Batterie basierend auf den Spannungsschätzungsinformationen und zweiten Spannungsinformationen, die sich auf die für den zweiten Zeitraum gemessene Spannung der Batterie beziehen, wobei das Erzeugen der Spannungsschätzungsinformationen umfasst: Lernen der ersten Strominformationen und der ersten Spannungsinformationen durch einen Algorithmus; und Erzeugen der Spannungsschätzungsinformationen basierend auf dem trainierten Algorithmus.

13. Betriebsverfahren nach Anspruch 13, wobei das Bestimmen (S130) des Zustands der Batterie das Bestimmen umfasst, dass eine Anomalie in der Batterie auftritt, wenn eine Differenz zwischen den Spannungsschätzungsinformationen und den zweiten Spannungsinformationen größer als oder gleich einem Schwellenwert ist.

## Revendications

1. Appareil de gestion de batterie (100) comprenant : une unité de mesure (110) configurée pour mesurer un courant et une tension d'une batterie ; et un contrôleur (120) configuré pour : générer des informations d'estimation de tension en estimant la tension de la batterie pour une seconde période de temps après une première période de temps sur la base de premières informations de courant relatives au courant de la batterie mesuré pour la première période de temps et de premières informations de tension relatives à la tension de la batterie mesurée pour la première période de temps, déterminer un état de la batterie sur la base des informations d'estimation de tension et de secondes informations de tension relatives à la tension de la batterie mesurée pour la seconde période de temps ; dans lequel le contrôleur (120) est en outre configuré pour : apprendre les premières informations de courant et les premières informations de tension par l'intermédiaire d'un algorithme ; et générer les informations d'estimation de tension sur la base de l'algorithme entraîné.

2. L'appareil de gestion de batterie selon la revendication 1, dans lequel le contrôleur (120) est en outre configuré pour déterminer qu'une anomalie se produit dans la batterie lorsqu'une différence entre les informations d'estimation de tension et les secondes informations de tension est supérieure ou égale à une valeur de seuil.

3. L'appareil de gestion de batterie selon la revendication 1, dans lequel le contrôleur (120) est en outre configuré pour générer les informations d'estimation de tension sur la base de secondes informations de courant relatives au courant de la batterie mesuré pour la seconde période de temps et d'informations de tension initiale de la batterie mesurées pour la seconde période de temps.

4. L'appareil de gestion de batterie selon la revendication 1, dans lequel l'algorithme comprend un algorithme de mémoire à long et court terme, LSTM.

5. L'appareil de gestion de batterie selon la revendication 1, dans lequel le contrôleur (120) est en outre configuré pour mettre à jour l'algorithme sur la base des secondes informations de tension et des secondes informations de courant relatives au courant de la batterie mesuré pour la seconde période de temps.

6. L'appareil de gestion de batterie selon la revendication 1, comprenant en outre une unité de stockage (130), dans lequel l'unité de stockage (130) est en outre configurée pour stocker un algorithme entraîné à chaque première période de temps.

7. L'appareil de gestion de batterie selon la revendication 6, dans lequel le contrôleur (120) est en outre configuré pour générer des informations d'estimation de tension d'une batterie de remplacement pour la seconde période de temps sur la base de l'algorithme stocké lorsqu'il y a la batterie de remplacement.

8. L'appareil de gestion de batterie selon la revendication 1, dans lequel le contrôleur (120) est en outre configuré pour générer les informations d'estimation de tension lorsque la batterie a un état de santé, SoH, dans une plage spécifique.

9. L'appareil de gestion de batterie selon la revendication 8, dans lequel le contrôleur (120) est en outre configuré pour changer un algorithme pour générer les informations d'estimation de tension lorsque le SoH de la batterie sort de la plage spécifique.

10. L'appareil de gestion de batterie selon la revendication 1, dans lequel le contrôleur (120) est en outre configuré pour mettre à jour l'algorithme pour générer les informations d'estimation de tension pour chaque première période de temps.

11. L'appareil de gestion de batterie selon la revendication 1, dans lequel le contrôleur (120) est en outre configuré pour : entraîner un algorithme relatif à une relation entre les premières informations de courant et les premières informations de tension ; et générer les informations d'estimation de tension sur la base de l'algorithme entraîné.

12. Procédé de fonctionnement d'un appareil de gestion de batterie (100), le procédé de fonctionnement comprenant : la mesure (S110) d'un courant et d'une tension d'une batterie ; et la génération d'informations d'estimation de tension (S120) en estimant la tension de la batterie pour une seconde période de temps après une première période de temps sur la base de premières informations de courant relatives au courant de la batterie mesuré pour la première période de temps et de premières informations de tension relatives à la tension de la batterie mesurée pour la première période de temps ; et la détermination (S130) d'un état de la batterie sur la base des informations d'estimation de tension et de secondes informations de tension relatives à la tension de la batterie mesurée pour la seconde période de temps, dans lequel la génération des informations d'estimation de tension comprend :
l'apprentissage des premières informations de courant et des premières informations de tension par l'intermédiaire d'un algorithme ; et la génération des informations d'estimation de tension sur la base de l'algorithme entraîné.

13. Le procédé de fonctionnement selon la revendication 13, dans lequel la détermination (S130) de l'état de la batterie comprend la détermination qu'une anomalie se produit dans la batterie lorsqu'une différence entre les informations d'estimation de tension et les secondes informations de tension est supérieure ou égale à une valeur de seuil.
